# EUROPÄISCHE PATENTSCHRIFT

(11) **EP 0 696 160 B1**
(45) Veröffentlichungstag und Bekanntmachung des Hinweises auf die Patenterteilung: **20.08.1997**
(21) Anmeldenummer: 95111250.7
(22) Anmeldetag: 18.07.1995
(51) Int. Cl.: H05K 7/20, H01L 23/367

(54) **Kühlvorrichtung für elektrische bzw. elektronische Bauelemente sowie Verfahren zu deren Herstellung**
Cooling device for electrical or electronic components and method for making the same
Drain thermique pour composants électriques ou électroniques et procédé de fabrication dudit drain thermique

(30) Priorität: 02.08.1994 DE 9412460 U
(43) Veröffentlichungstag der Anmeldung: 07.02.1996
(73) Patentinhaber: Hoogovens Aluminium Profiltechnik GmbH, D-88264 Vogt (DE)
(72) Erfinder: Gönner, Johannes, D-88276 Berg (DE); Masatz, Joachim, S-91315 Höchstadt (DE)
(74) Vertreter: Müller, Hans-Jürgen, Dipl.-Ing.

(56) Entgegenhaltungen:
- EP-A- 0 483 058
- WO-A-87/02443
- US-A- 1 830 375

## Beschreibung

Die Erfindung bezieht sich auf eine Kühlvorrichtung für elektrische bzw. elektronische Bauelemente der im Oberbegriff des Anspruches 1 genannten Gattung sowie auf ein Verfahren zu deren Herstellung.

Eine derartige Kühlvorrichtung ist bereits bekannt (WO87/02443).

Eine weitere Kühlvorrichtung ist aus der DE-PS 25 02 472 bekannt. Dabei sind die rippenartigen Kühlelemente aus Aluminiumplatten hergestellt, welche jeweils mit Enden in parallel verlaufende Nuten der Grundplatte eingepreßt sind. Die Nutenwandungen weisen Vorsprünge und Vertiefungen auf, um die Kühlelemente nach dem Einpressen in die Nuten gut zu verankern. Das Herstellen dieses Kühlkörpers ist verhältnismäßig aufwendig.

Darüber hinaus ist es bekannt (DE-PS 35 18 310 und EP-OS 0 483 058), die einzelnen rippenartigen Kühlelemente dadurch fest in der Grundplatte zu verankern, daß die Zwischenstege zwischen den Nuten in der Grundplatte nach dem Einsetzen der Enden der Kühlelemente an die Kühlelementewandung angepreßt werden, wodurch sich die Breite der Nuten verringert. Hier wird empfohlen, die Außenflächen der plattenförmigen bzw. als Hohlkörper ausgebildeten Kühlelemente mit Erhöhungen und Vertiefungen zu versehen, um die Verankerung der einzelnen Kühlelemente in der Grundplatte zu verbessern.

Ferner ist es bekannt (DE-OS 41 06 437), Kühlelemente aus dünnen Drähten herzustellen. Die einzelnen Drähte werden mäanderförmig gebogen, so daß ein und derselbe Draht jeweils Bestandteil einer Vielzahl von Kühlelementen bildet; dabei ist eine Vielzahl solcher Drähte hintereinander angeordnet, um rippenartige Strukturen zu formen. Die Verbindung der dünnen Drähte mit der Grundplatte erfolgt mittels einer metallischen Verbindung. Dabei ist es auch bekannt, eine Kühlmittelströmung von oben auf die rippenförmige Struktur bestehend aus den vielen Kühldrähten aufzublasen.

Ferner ist es bekannt (EP-PS 0 123 795), aus einem quaderförmigen Block einzelne im Querschnitt wiederum quaderförmige Kühlelemente durch kreuzweises Ausfräsen herzustellen. Der Block wird von beiden Stirnseiten her so mit Fräsrillen versehen, daß sich ein im Querschnitt mäanderartiger Verlauf des verbliebenen Werkstückmaterials ergibt. Auch hier ist der Herstellungsaufwand verhältnismäßig groß.

Außerdem ist es auch bekannt (DE-GM 92 14 061 und 93 02 754), die Kühlelemente zu einer Baueinheit zusammen zu fassen, indem die Kühlrippen jeweils an einem Ende zu einer Platte zusammen-gefaßt sind, die ihrerseits beispielsweise mit Hilfe einer Wärmeleitpaste mit der Grundplatte in Verbindung steht, welche die elektronischen Bauelemente, beispielsweise Halbleiterelemente, Thyristoren, aufweist.

Ferner ist es bekannt (US-A-1 830 375), an beiden Außenseiten eines flachen Hohlrohres bandförmige Mäander anzusetzen und mittels einer Drahtwendel festzuhalten.

Der Erfindung liegt die Aufgabe zugrunde, eine Kühlvorrichtung der eingangs genannten Gattung technisch und funktionell zu verbessern und herstellungsmäßig zu vereinfachen.

Die Erfindung ist im Anspruch 1 gekennzeichnet und in Unteransprüchen sind besonders bevorzugte Ausbildungen derselben beansprucht. Das erfindungsgemäße Verfahren ist im Anspruch 7 gekennzeichnet.

Gemäß der Erfindung sind mindestens zwei Kühlelemente zu einer einstückigen Baueinheit zusammengefaßt; diese Baueinheit besteht aus einem Band des thermisch gut leitfähigen Materials, das entweder mäanderförmig bzw serpentinenartig gebogen ist, so daß benachbarte Windungen jeweils rippenartige Kühlelemente bilden, oder das ein U-förmiges Profil bildet, so daß mehrere, insb. eine Vielzahl von mindestens vier solcher U-Profile kammsegmentartig im Abstand nebeneinander an einer Seite der Grundplatte angeordnet ist. Der Abstand der Profile ist um ein Vielfaches kleiner als deren Ausdehnung von der Grundplatte weg, d.h. als deren Bauhöhe.

Der Profilfuß, d.h. der die beiden Profilschenkel verbindende Stegteil, ist in einer Längsnut der Grundplatte verankert, so daß sich gleichzeitig ein Flächenkontakt zu Längsnutinnenwänden ergibt und sich ein guter Wärmeübergang realisieren läßt. Die Verankerung kann durch ein zwischen die Profilschenkel eingelegtes und diese im Fußbereich nach außen drängender Drahtstück erfolgen. Bevorzugt wird zur Herstellung der Kühlelemente-Baueinheit ein lotplattiertes bandförmiges Blech verwendet, bei dem das Lot, mit dem die Baueinheit in der Längsnut mit der Grundplatte verbunden wird, als Lotschicht schon auf der thermisch gut leitfähigen Trägerschicht, dem Blech, plattiert ist. Besonders bevorzugt wird eine plattierte Aluminiumlegierung, beispielsweise vom Typ AlMn oder AlMnMg. Solche plattierte Aluminiumlegierungen eignen sich insbesondere zur Ofenlötung; sie werden vor allem durch Walzen hergestellt und erhalten für die erfindungsmäßigen Zwecke durch Biegen die mäanderförmige bzw. serpentinenartige Struktur. Dabei empfiehlt es sich, die Lotschicht an den Außenseiten derjenigen Mäanderenden freiliegen zu lassen, an welchen die Verbindung mit der Grundplatte erfolgt.

Vielfach genügt es, die im Profil mäanderförmige Baueinheit an einer Seite, an der sich Mäanderenden befinden, an die Grundplatte anzulegen und dort aufzulöten, was herstellungstechnisch den geringsten Aufwand macht und dennoch eine gute Verbindung und auch einen ausreichenden Wärmeübergang von der Grundplatte zur mäanderförmigen Baueinheit sicherstellt.

Anstelle der oder ergänzend zur Lötverbindung kann das mäanderförmige Band oder können die Profile mittels langgestreckten Drahtstücken in die Längsnuten der Grundplatte eingedrückt und dort bleibend verformt und hierdurch fest verankert sein.

Der Wärmeübergang und die Verankerung werden noch verbessert, wenn die stranggepreßte Grundplatte im Querschnitt schwalbenschwanzförmige Längsnuten aufweist. In die breiteren Enden der schwalbenschwanzförmigen Längsnuten werden Drahtstücke eingelegt, um das Verbinden mit der Grundplatte durch Einklemmen bzw. Einkeilen zu erleichtern und nicht nur eine gute mechanische Verbindung herzustellen, sondern auch den thermischen Übergangswiderstand noch weiter auch ohne Verlöten zu vermindern. Die Kühlwirkung wird hierdurch noch weiter verbessert und ein selbständiges Lösen der "Profile" auch bei starkem Erwärmen wird verhindert.

Ausführungsbeispiele der Erfindung werden im folgenden näher erläutert. Dabei zeigen:
- Fig. 1: eine schematische Darstellung einer erfindungsgemäßen Kühlvorrichtung;
- Fig. 2: eine Querschnittsansicht auf die Kühlvorrichtung einer anderen erfindungsgemäßen Version;
- Fig. 3: eine Querschnittsansicht auf die zu einer eiiistückigen Baueinheit vereinten einzelnen Kühlelemente in Form eines mäanderförmigen in Falten gelegten Bandes;
- Fig. 4: einen Teilquerschnitt des zur Herstellung der Kühlelemente dienenden Bandes;
- Fig. 5-7: alternative Querschnittansichten der Kühlvorrichtung und
- Fig. 8: einen vergrößerten Teilausschnitt aus dem Verankerungsbereich des Bandes bzw. Profils in einer Grundplattennut im Querschnitt.

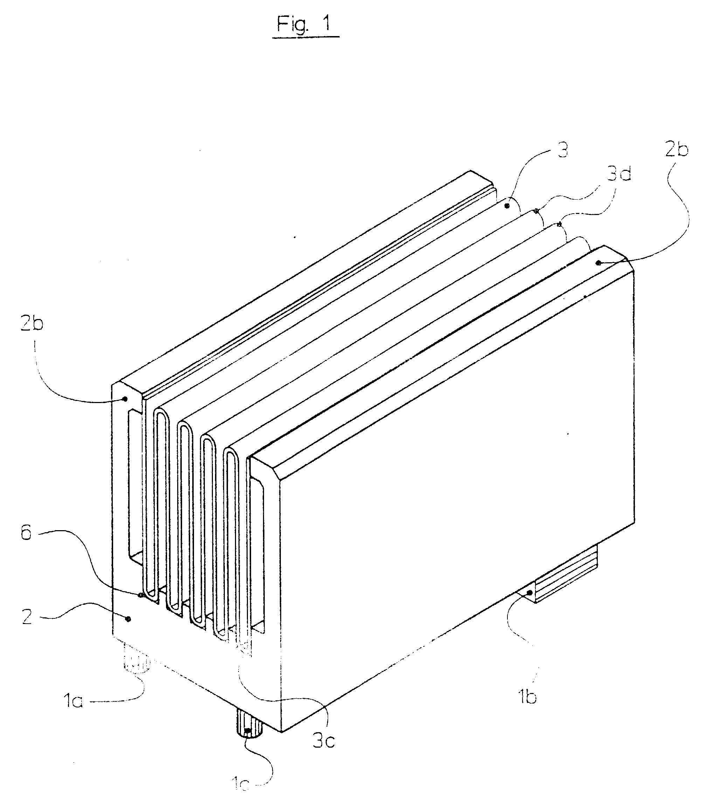

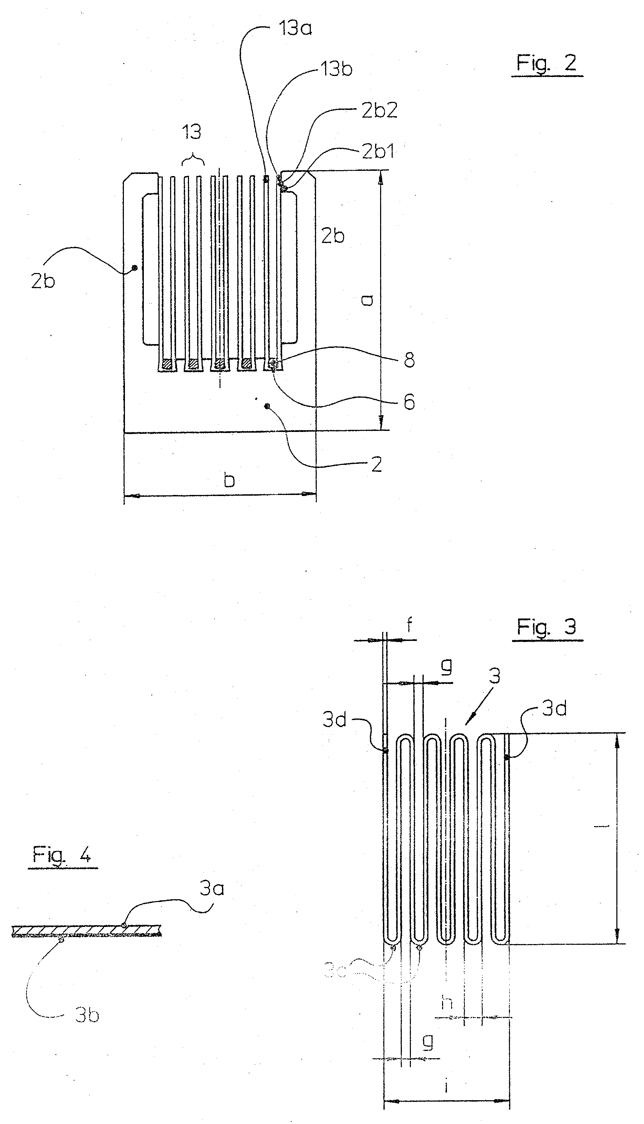

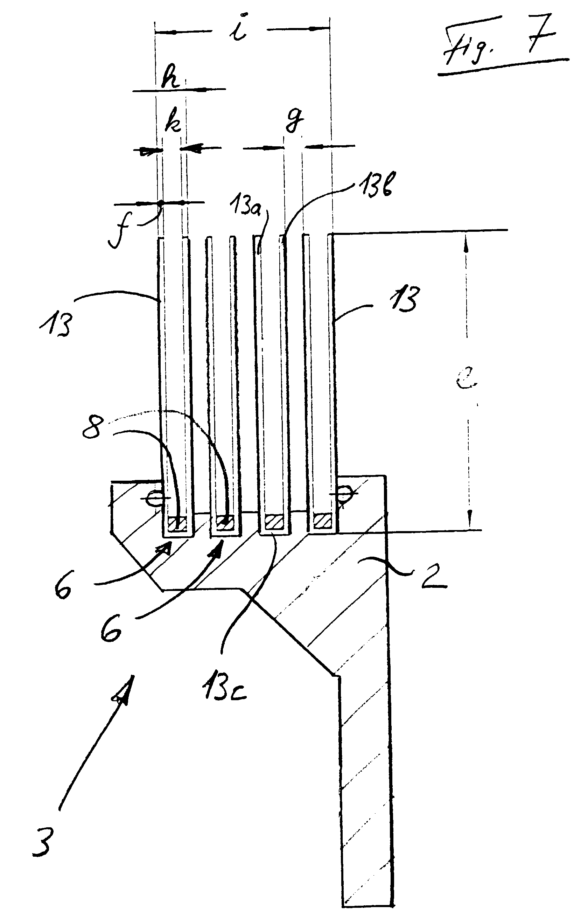

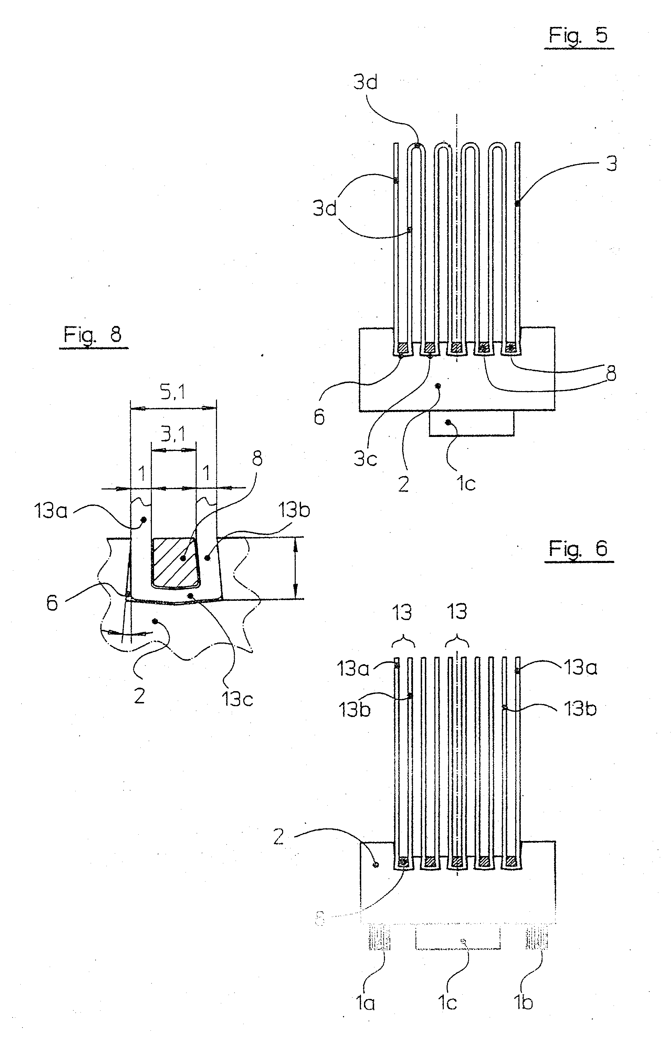

Gemäß Figur 1 ist eine Reihe von elektronischen Bauelementen 1a, 1b und 1c an einer Fläche der Grundplatte 2 so befestigt, daß sich in den elektronischen Bauelementen 1a, 1b und 1c entwickelnde Wärme gut auf die Grundplatte 2 abgeleitet wird. Die Grundplatte 2 besteht z.B. aus Aluminium und bildet ein Profilteil mit den zwei Seitenplatten 2b, welche das zu der Baueinheit 3 mäanderförmig gebogene Band aus lotplattiertem oder handelsüblichem Aluminiumblech seitlich abstützen. In schwalbenschwanzförmige Längsnuten 6 (gemäß Numerierung nach Fig. 8) der Grundplatte 2 ist die aus dem Band gebildete Baueinheit 3 mit den bei diesem Beispiel etwa halbkreisförmig gebogene Mäanderenden 3c (gem. Fig. 3) eingesetzt und verlötet. Als Lot empfiehlt sich ein solches, das sich herstellungstechnisch schnell und mechanisch fest verlöten läßt und darüber hinaus einen nur geringen Wärmeübergangswiderstand zwischen der Grundplatte 2 und der Baueinheit 3 bildet.

Die in den Figuren 2 und 3 dargestellten Abmessungen bei dem Ausführungsbeispiel der Erfindung sind folgende:

| | |
|---|---|
| a = | 60 mm |
| b = | 47 mm |
| e = | 48 mm |
| f = | 1 mm |
| g = | 2 mm |
| h = | 4 mm |
| i = | ca.30 mm. |

Die elektronischen Bauelemente 1a, 1b, 1c können auch an den als Seitenplatten 2b wirkenden Profilschenkeln der Grundplatte 2 angeordnet sein.

Gemäß Fig. 4 ist die aus Aluminium bestehende Trägerschicht 3a des blechartigen Bandes für die Baueinheit 3 einer Schichtdicke von 0,9 mm mit einer 0,1 mm dicken Lötschicht 3b aus Spezial-Hartlot aus insb. AlSi an einer Seite überzogen.

Auch gemäß Fig. 2, 5, 6, 7 und 8 ist die Baueinheit 3 oder sind die U-förmigen Profile 13 mittels geraden langgestreckten Drahtstücken 8 in den Längsnuten 6 verankert, wie dies in Fig. 8 verdeutlicht ist; dabei sind die langgestreckten Drahtstücke 8 zwischen benachbarten Profilschenkeln 13 des mäanderförmigen Bandes bzw. Profils 13 insb. durch bleibende Verformung so eingeklemmt, daß Mäanderenden 3c (im Bereich der "Täler") oder die unteren Teile der Profilschenkel 13a, 13b in der Nähe des Stegteils 13c innerhalb der Längsnuten 6 leicht nach außen unter einem Winkel von z.B. 5° aufgeweitet werden und sich an die Innenflächen der schwalbenschwanzförmigen Längsnuten 6 anlegen.

Gemäß Fig. 2, 6 und 7 sind die Drahtstücke 8 am Grund der im Querschnitt U-förmigen Profilteile 13, d.h. auf dem Stegteil 13c, zwischen die Profilschenkel 13a und 13b eingeklemmt und in den Längsnuten 6 verankert.

Die oberen Enden 2bl der Seitenplatte 2b bzw. Seitenschenkel sind bevorzugt innen vorspringend, um Anlage- und Kontaktflächen 2b2 für das Band oder den anliegenden Schenkel 13b der Profils 13 zu bilden.

Bevorzugte Maße für das Vorzugsbeispiel von Figur 7 sind:

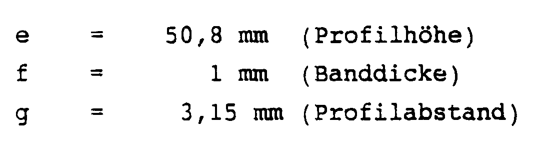

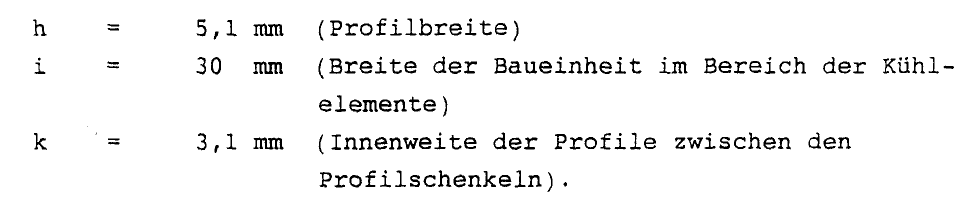

Das Kühlelement gemäß der Baueinheit 3 von Figur 7 wird wie folgt hergestellt:

zuerst wird der Profilteil der Grundplatte 2 mit dem im Querschnitt insb. schwalbenschwanzförmigen (Fig. 8) Längsnuten 6 aus Aluminium stranggepreßt. Danach werden die 4 U-förmigen Profile 13 mit ihrem den Stegteil 13c aufweisenden Boden bzw. Ende in die Längsnuten 6 eingesteckt. Anschließend werden Drahtstücke 8 mit insb. Rechteckquerschnitt in die Zwischenräume zwischen den Profilschenkeln 13a, 13b eingesteckt und zweckmäßigerweise mittels eines gemeinsamen Werkzeugs, z.B. in einer Presse, bis zum Boden, d.h. Stegteil 13, der Profile 13 eingeschoben; dabei müssen sie eine Kraft überwinden oder werden so stark gedrückt und gepreßt, wodurch die benachbarten Teile der Profilschenkel 13a, 13b bleibend verformt werden und sich an die Seitenwände der Längsnuten 6 flächig unter Klemmwirkung anlegen.

Die Profile können nicht nur wie oben erwähnt aus Aluminiumblech hergestellt sein; auch Kupferblech oder andere thermisch gut leitfähige Werkstoffe sind gut geeignet. Gleichfalls eignet sich für die Drahtstücke 8 außer Aluminium auch Kupfer; auch Legierungen solcher mit anderen oder anderer Werkstoffe sind anwendbar.

## Patentansprüche

1. Kühlvorrichtung für elektrische bzw. elektronische Bauelemente
mit einer Grundplatte (2) zur Befestigung der zu kühlenden Bauelemente und mit rippenartigen Kühlelementen aus thermisch gut leitfähigem Material,
bei der die Kühlelemente im wesentlichen parallel zueinander und im Abstand voneinander in wärmeübertragendem Kontakt mit der Grundplatte (2) verbunden und mindestens zwei Kühlelemente zu einer einstückigen bandförmigen Baueinheit (3) zusammengefaßt sind, die im Querschnitt mindestens ein U-förmiges Profil (13) aufweist, dessen Fuß bzw. dessen die beiden Profilschenkel (3d, 13a, 13b) verbindender Stegteil (3c, 13c) an der Grundplatte (2) verankert ist,
**dadurch gekennzeichnet,**
daß die Enden der Kühlelemente in schlitzartige Längsnuten (6) der Grundplatte (2) eingreifen und durch ein zwischen die Profilschenkel (3d, 13a, 13b) im Bereich des Endes eingeklemmtes bzw. eingepreßtes langgestrecktes Drahtstück (8) und/oder durch eine an der Außenseite der Profilschenkel (3d, 13a, 13b) angeordnete, plattierte Lötschicht (3b) verankert sind.

2. Kühlvorrichtung nach Anspruch 1, **dadurch gekennzeichnet,**
daß mehrere U-förmige Profile zu einer mäander- bzw. serpentinenförmigen Baueinheit (3) zusammengefaßt sind.

3. Kühlvorrichtung nach Anspruch 1,
**dadurch gekennzeichnet,**
daß eine Mehrzahl U-förmiger Profile (13) kammsegmentartig parallel und im Abstand nebeneinander mit der Grundplatte (2) verbunden ist.

4. Kühlvorrichtung nach einem der vorhergehenden Ansprüche,
**dadurch gekennzeichnet,**
daß die Grundplatte (2) mit den Längsnuten (6) stranggepreßt ist.

5. Kühlvorrichtung nach Anspruch 4,
**dadurch gekennzeichnet,**
daß die Längsnuten (6) der Grundplatte (2) im Querschnitt schwalbenschwanzförmig ausgebildet sind.

6. Kühlvorrichtung nach einem der vorhergehenden Ansprüche,
**dadurch gekennzeichnet,**
daß das Profil (13) aus einem Verbundwerkstoff aus mindestens zwei Schichten, nämlich einer thermisch gut leitfähigen Trägerschicht (3a) und einer plattierten Lötschicht (3b) aus einem Hartlot besteht.

7. Verfahrung zur Herstellung einer Kühlvorrichtung nach einem der vorhergehenden Ansprüche, bei dem die Kühlelemente in die Längsnuten (6) der Grundplatte (2) eingesetzt und mit dieser kraftschlüssig verbunden werden,
**dadurch gekennzeichnet,**
daß die mäanderförmige Baueinheit (3) und/oder eine Mehrzahl von U-förmigen Profilen (13) mit deren den Stegteil (3c, 13c) bildenden Enden in die Längsnuten (6) eingesetzt und anschließend die langgestreckten Drahtstücke (8) derart bis an den Boden der U-förmigen Profile (13) gepreßt werden, daß sich der Stegteil (3c, 13c) und/oder benachbarte Teile der Profilschenkel (3d, 13a, 13b) bleibend unter Anlage mit Flächenkontakt mit gutem Wärmeübergang an Innenwände der Längsnuten (6) verformen.

## Claims

1. A cooling device for electrical or electronic components, comprising
a base plate (2) for attachment of the components to be cooled and rib-like cooling members of a material being a good thermal conductor,
wherein the cooling members are connected to be substantially parallel to and spaced apart from each other in heat transfer contact with the base plate (2) and at least two cooling members are combined to form an integral band-shaped unit (3) comprising at least one section (13) having a U-shaped cross-section, whose foot or, respectively, the web portion (3c, 13c) connecting the two section legs (3d, 13a, 13b) are anchored on the base plate (2),
**characterised in**
that the ends of the cooling members engage in slot-like longitudinal grooves (6) of the base plate (2) and are anchored via an elongated wire piece (8) clamped or pressed between the section legs (3d, 13a, 13b) in the end region and/or via a clad solder layer (3b) disposed on the outer side of the section legs (3d, 13a, 13b)

2. A cooling device according to claim 1,
characterised in
that a plurality of U-shaped sections are combined to form a meander-shaped or, respectively, serpentine-shaped unit (3).

3. A cooling device according to claim 1,
**characterised in**
that a plurality of U-shaped sections (13) are connected with the base plate (2) to be parallel and adjacent to each other to form a comb-like segment.

4. A cooling device according to any of the preceding claims,
**characterised in**
that the base plate (2) together with the longitudinal grooves (6) is extruded.

5. A cooling device according to claim 4,
**characterised in**
that the longitudinal grooves (6) of the base plate (2) are configured to have a dovetailed cross-section.

6. A cooling device according to any of the preceding claims,
**characterised in**
that the section (13) consists of a composite material comprising at least two layers, namely a carrier layer (3a), which is a good thermal conductor, and a clad solder layer (3b) of a hard solder.

7. A method for manufacturing a cooling device according to any of the preceding claims, wherein the cooling members are inserted into the longitudinal grooves (6) of the base plate (2) and are non-positively connected therewith,
**characterised in**
that the ends of the meander-shaped unit (3) and/or a plurality of U-shaped sections (13), which constitute the web portion (3c, 13c), are inserted into the longitudinal grooves (6) and that, subsequently, the elongated wire pieces (8) are pressed down to the bottom of the U-shaped sections (13) such that the web portion (3c, 13c) and/or adjacent portions of the section legs (3d, 13a, 13b) are permanently deformed to bear against the inner walls of the longitudinal grooves (6) under surface contact with good heat transfer.

## Revendications

1. Dispositif de refroidissement pour composants électriques ou électroniques
comportant une plaque de base (2) pour la fixation des composants à refroidir ainsi que des éléments de refroidissement du type d'ailettes en matériau thermiquement bon conducteur,
dans lequel les éléments de refroidissement sont reliés sensiblement parallèlement entre eux et à distance les uns des autres, en contact de transmission de chaleur, avec la plaque de base (2) et au moins deux éléments de refroidissement sont réunis en une unité de construction (3) en forme de bande d'un seul tenant, qui présente dans la section transversale au moins un profilé (13) en U, dont le pied ou la partie de dos (3c, 13c), reliant les deux branches (3d, 13a, 13b) du profilé, est ancré sur la plaque de base (2),
caractérisé
en ce que les extrémités des éléments de refroidissement s'engagent dans des rainures longitudinales (6), en fentes de la plaque de base (2) et sont ancrées par une pièce de fil (8) allongée, serrée ou pressée à l'intérieur entre les branches (3d, 13a, 13b) du profilé, dans la zone de l'extrémité et/ou par une couche de brasage (3b) plaquée, située sur le côté extérieur des branches (3d, 13a, 13b) du profilé.

2. Dispositif de refroidissement selon la revendication 1,
caractérisé
en ce que plusieurs profilés en U sont réunis en une unité de construction (3) en forme de méandres ou de serpentins.

3. Dispositif de refroidissement selon la revendication 1,
caractérisé
en ce qu'une pluralité de profilés (13) en U est reliée parallèlement, à la manière de segments de peigne et à distance les uns des autres, avec la plaque de base (2).

4. Dispositif de refroidissement selon l'une des revendications précédentes,
caractérisé
en ce que la plaque de base (2) est extrudée avec les rainures longitudinales (6).

5. Dispositif de refroidissement selon la revendication 4,
caractérisé
en ce que les rainures longitudinales (6) de la plaque de base (2) ont une section transversale en forme de queue d'aronde.

6. Dispositif de refroidissement selon l'une des revendications précédentes,
caractérisé
en ce que le profilé (13) est constitué d'un matériau composite fait d'au moins deux couches, à savoir une couche de support (3a) thermiquement bonne conductrice et une couche de brasage (3b) plaquée en métal d'apport de brasage fort.

7. Procédé de fabrication d'un dispositif de refroidissement selon l'une des revendications précédentes, dans lequel les éléments de refroidissement sont insérés dans les rainures longitudinales (6) de la plaque de base (2) et sont reliés avec celles-ci par force,
caractérisé
en ce que l'unité de construction (3) en forme de méandres et/ou une pluralité de profilés (13) en U sont insérés dans les rainures longitudinales (6), avec leurs extrémités formant la partie de dos (3c, 13c) et ensuite les pièces de fil (8) allongées sont pressées jusqu'au fond des profilés (13) en U, de manière que la partie de dos (3c, 13c) et/ou les parties voisines des branches (3d, 13a, 13b) du profilé se déforment en restant en application, avec un contact superficiel et un bon transfert de chaleur, contre des parois intérieures des rainures longitudinales (6).
